# EUROPEAN PATENT APPLICATION

(11) **EP 1 489 662 A2**
(43) Date of publication of application: **22.12.2004**
(21) Application number: 04253545.0
(22) Date of filing: 14.06.2004
(51) Int. Cl.: H01L 29/737, H01L 21/331, H01L 29/732

(54) **Bipolar junction transistor and method of manufacturing the same**

(30) Priority: 13.06.2003 KR 2003038381; 04.05.2004 US 837609
(71) Applicant: Samsung Electronics Co., Ltd., Suwon-si, Gyeonggi-do (KR)
(72) Inventor: Yang, Bong-gil, Yeoungtong-gu, Suwon-si, Gyeonggi-do (KR); Shin, Heon-jong, Suji-eub, Yongin-si, Gyeonggi-do (KR); Park, Kang-wook, Gangnam-gu, Seoul (KR)
(74) Representative: Mounteney, Simon James

(57) **Abstract**

A bipolar transistor includes a substrate having a collector region (210) of a first conductivity type, a base layer (230) of a second conductivity type extending horizontally over the collector region, and an emitter region (240) of the first conductivity type at least partially contained in the base layer. The bipolar transistor also includes an emitter electrode (261) confronting an upper surface of the emitter region, and a base electrode (291) confronting an upper surface of the base layer. A vertical profile of at least a portion the base electrode (291) is equal to or greater than a vertical profile of the emitter electrode (261).

## Description

### BACKGROUND OF THE INVENTION

### 1. Field of the Invention

The present invention generally relates to bipolar transistors. More particularly, the present invention relates to

### 2. Description of the Related Art

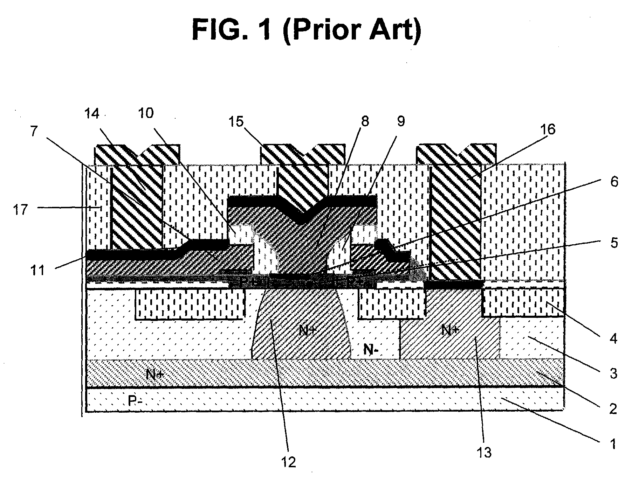

FIG. 1 is a cross-sectional view of a conventional vertical bipolar transistor. In this example, an NPN transistor is shown, and accordingly, an N+ buried collector region 2 is located at a depth within a N-collector region 3 formed over a P- substrate 1.
Typically, the N- collector region 3 is formed by epitaxial growth over the P- substrate 1. Also, as shown, LOCUS or STI insulating layers 4 are formed to isolate surface regions of the N- collector region 3.

A P+ base layer 5 is formed by epitaxial growth of single-crystal Si or SiGe over the N- collector region 3, and an N+ emitter region 6 is formed by doping impurities to a given depth within the P+ base layer 5. A P+ poly-silicon base electrode 7 and an N+ poly-silicon emitter electrode 8 respectively contact surfaces of the base layer 5 and emitter region 6. The emitter region 6 is usually formed by diffusion of impurities from the poly-silicon emitter electrode 8 into the base layer 5. The poly-silicon emitter electrode 8 is electrically insulated from the poly-silicon base electrode 7 by sidewall spacers 9 and insulating layer 10. Further, each of the poly-silicon base and emitter electrodes 7, 8 is covered with a silicide layer 11 for low-resistance contact to metal interconnects 14 and 15, respectively. As shown, the metal interconnects are contained in contact holes formed in an insulating layer 17.

An overdoped N+ region 12 is located below the emitter region 6 and extends between the base layer 5 and the N+ buried collector region 2. Likewise, an N+ collector sink 13 extends from the N+ buried collector region 2 to the surface of the N- collector region 3 for connection to a metal collector interconnect 16 via one of the silicide layers 11.

As is well know in the art, conductivity of the bipolar transistor is achieved by the injection of minority carriers from the emitter region 6 into the base layer 5, thereby electrically connecting the emitter region 6 to the underlying N+ collector region 12. In this state, an electrical path is established from the emitter electrode 8 to the collector sink 13 via the overdoped collector region 12 and the buried collector region 2.

Performance efficiencies of the bipolar transistor are highly dependent on emitter characteristics, and various techniques have been applied in the art in an effort to improve the emitter. For example, a so-called heterojunction bipolar transistor is known in which the emitter region is formed with a higher band gap than the underlying base layer, thus facilitating the injection of minority carriers into the base layer. One exemplary heterojunction device is formed by stacking epitaxially grown layers SiGe and Si over the collector region, and then doping a region of the upper Si layer to define the emitter. The bandgap of the Si emitter is wider than that of SiGe base, thus enhancing injection efficiency. It is also known that injection efficiency can be further enhanced by providing a graded distribution of Ge in the SiGe layer to achieve a non-uniform band-gap.

Notwithstanding these and other improvements, there still exists a demand for bipolar transistors having improved emitter characteristics to therefore obtain higher performance efficiencies.

During the manufacture of the conventional bipolar transistor of FIG. 1, the emitter electrode 8 is formed after the base electrode 7. For this reason, the emitter electrode 8 exhibits a much taller profile than the base electrode 7, and a substantial distance exists from the metal contact 15 (or silicide) to the emitter region 5. This conventional configuration is therefore characterized by a long electrical pathway within the poly-silicon emitter electrode 8, which increases the emitter resistive component of the device, thus degrading performance.

Further, in the conventional manufacturing process, the emitter electrode 5 is substantially exposed to plasma when contact holes for the interconnects 14, 15 and 16 are formed through the insulating layer 17. That is, while completing the formation of the contact holes for the deeper interconnects 14 and 16, the exposed silicide of the emitter electrode 8 may be partially or completely etched through. This increases the contact resistance at the interface between the interconnect 15 and the emitter electrode 8. The result is a bipolar transistor having non-uniform and/or non-stable performance characteristics.

### SUMMARY OF THE INVENTION

According to an aspect of the present invention, a bipolar transistor is provided which includes a substrate having a collector region of a first conductivity type, a base layer of a second conductivity type extending horizontally over the collector region, and an emitter region of the first conductivity type at least partially contained in the base layer. The bipolar transistor also includes an emitter electrode confronting an upper surface of the emitter region, and a base electrode confronting an upper surface of the base layer, where a vertical profile of at least a portion the base electrode is equal to or greater than a vertical profile of the emitter electrode.

According to another aspect of the present invention, a bipolar transistor is provided which includes a substrate having a collector region of a first conductivity type, a base layer of a second conductivity type extending horizontally over the collector region, and an emitter region of the first conductivity type at least partially contained in the base layer. The bipolar transistor further includes an emitter electrode of the first conductivity type confronting an upper surface of the emitter region, a base electrode of the second conductivity type confronting an upper surface of the base layer, an insulating layer located over the emitter electrode and the base electrode, a first metal contact extending vertically through the insulating layer to an upper surface of the base electrode, and a second metal contact extending vertically through the insulating layer to an upper surface of the emitter electrode. A vertical length through the insulating layer of the second metal contact is equal to or more than a vertical length through the insulating layer of the first metal contact.

According to still another aspect of the present invention, a method of manufacturing a bipolar transistor is provided which includes forming an emitter electrode of a first conductivity type over a first portion of a base layer of a second conductivity type, where the base layer is located over a collector region of the first conductivity type. The method further includes forming an emitter region of a first conductivity type at least partially within the first portion of the base layer, and forming a base electrode of the second conductivity type over a second portion of the base layer, and where the base electrode is formed after the emitter electrode is formed.

According to still another aspect of the present invention, a method of manufacturing a bipolar transistor is provided which includes forming an emitter electrode of a first conductivity type over a first portion of a base layer of a second conductivity type, where the base layer extends horizontally over a collector region of the first conductivity type. The method further includes forming an emitter region of a first conductivity type at least partially within the first portion of the base layer, and forming a base electrode of the second conductivity type over a second portion of the base layer, where a vertical profile of at least a portion the base electrode is equal to or greater than a vertical profile of the emitter electrode.

According to another aspect of the present invention, a method for forming a bipolar transistor is provided which includes forming an emitter region of a first conductivity type at least partially within a first portion of a base layer of a second conductivity type, where the base layer is located over a collector region of the first conductivity type. The method further includes forming an emitter electrode layer of a first conductivity type over the first portion of the base layer of a second conductivity type, forming a base electrode layer of the second conductivity type over a second portion of the base layer, and planarizing the emitter electrode layer and the base electrode layer to form an emitter electrode and a base electrode having coplanar surfaces.

### BRIEF DESCRIPTION OF THE DRAWINGS

The above and other aspects and features of the present invention will become readily apparent from the detailed description that follows, with reference to the accompanying drawings, in which:

FIG. 1 is a cross-sectional view of a conventional bipolar transistor;

FIG. 2 is a schematic cross-sectional view of a bipolar transistor according to an embodiment of the present invention;

FIGS. 3(A) through 3(F) are schematic cross-sectional views for describing a method of manufacturing the bipolar transistor of FIG. 2;

FIG. 4 is a schematic cross-sectional view of a bipolar transistor according to another embodiment of the present invention;

FIGS. 5(A) through 5(F) are schematic cross-sectional views for describing a method of manufacturing the bipolar transistor of FIG. 4;

FIG. 6 is a schematic cross-sectional view of a bipolar transistor according to an embodiment of the present invention; and

FIGS. 7(A) and 7(B) are schematic cross-sectional views for describing a method of manufacturing the bipolar transistor of FIG. 6.

### DETAILED DESCRIPTION OF THE PREFERRED EMBODIMENTS

The present invention will now be described in detail below with reference to several preferred but nonlimiting embodiments.

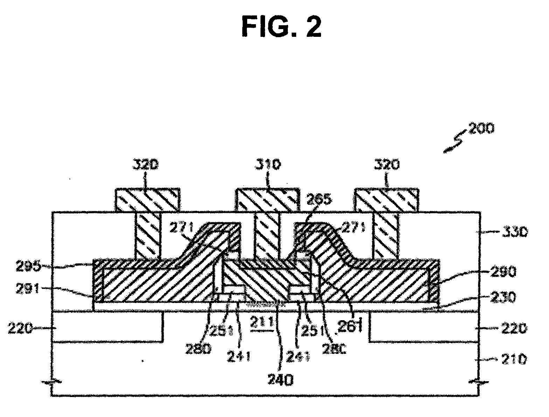

FIG. 2 illustrates a bipolar transistor 200 according to an embodiment of the present invention. In this example, an NPN transistor is described. An N+ buried collector region (not shown) is located at a depth within an N- collector region 210 formed of a single-crystalline structure. Also, as shown, LOCUS or STI insulating layers 220 are included to isolate surface regions of the N-collector region 210.

A single-crystal P+ base layer 230 is located over the N- collector region 210, and an N+ single-crystalline emitter region 240 extends to a given depth within the P+ base layer 230. Optionally, although not shown in FIG. 2, P+ base layers may be formed at a depth below the base layer 230 within N- collector region 210. As examples only, the base layer 230 may be a single layer of Si, or stacked layers of SiGe and Si. That is, although not shown in detail, the transistor of FIG. 2 may optionally be a heterojunction device which is characterized by the stacking of epitaxially grown layers SiGe and Si to form the base layer 230, then doping a region of the upper Si layer to define the emitter 240. The bandgap of the Si emitter is wider than that of SiGe base, thus enhancing injection efficiency. Injection efficiency can be further enhanced by providing a graded distribution of Ge in the SiGe layer to achieve a non-uniform band-gap.

A base electrode 291 is located on an upper surface of the base layer 230 and contacts a metal base contact 320 extending through an insulating (or dielectric) layer 330. The base electrode 291 may be covered with a silicide layer 295 to improve electrical connection to the base contact 320.

An N+ emitter electrode 261 contacts an upper surface of the emitter region 240 and contacts a metal emitter contact 310 extending through the insulating layer 330. Also, the emitter electrode 261 may be covered with a silicide layer 265 to improve electrical connection to the emitter contact 310.

The emitter electrode 261 is electrically insulated from the base electrode 291 by sidewall spacers 280 and insulating layers 241, 251 and 271.

Although not shown in FIG. 2, the collector configuration may be same as that of the conventional device shown in FIG. 1. That is, an overdoped N+ region may located below the emitter region 240, at reference number 211, which extends between the base layer 230 and an N+ buried collector region. Likewise, a laterally positioned N+ collector sink may extend from the N+ buried collector region to the surface of the device for connection to a metal collector contact.

Conductivity of the bipolar transistor of FIG. 2 is achieved by the injection of minority carriers from the emitter region 240 into the base layer 230, thereby electrically connecting the emitter region 240 to the underlying N+ collector region.

As shown in FIG. 2, at least a portion of the upper surface of the base electrode 291 is spaced farther from the surface of the N- collector region than is the upper surface of the emitter electrode 261. In other words, a vertical profile of at least a portion the base electrode 291 is equal to or greater than a vertical profile of the emitter electrode 261. Also, a vertical length through the insulating layer 330 of the emitter metal contacts 310 is preferably equal to or more than a vertical length through the insulating layer 330 of the base metal contact 320. This configuration may be optionally achieved by the latter described method of manufacture of an embodiment of the present invention. Advantageously, the profile height of the emitter electrode 261 is substantially reduced, thereby shortening the electrical pathway within the emitter electrode 261. The emitter resistive component of the device is decreased as a result, thus improving performance. Further improvements in emitter characteristics are realized in the case where the device of FIG. 2 is manufactured according to the method of manufacture described next.

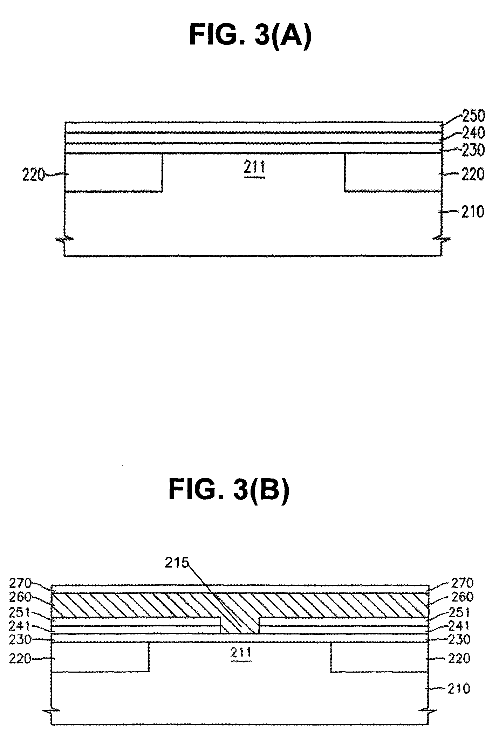

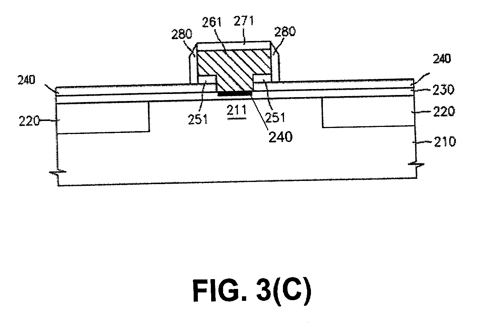

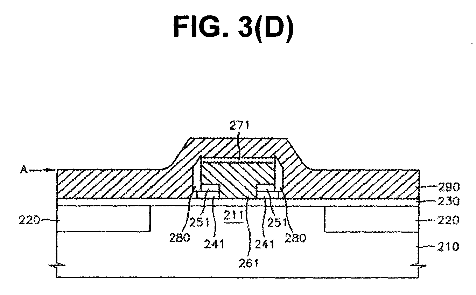

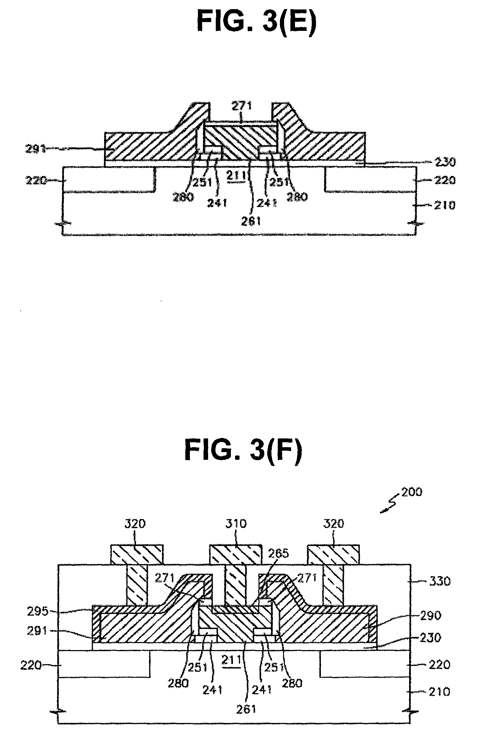

A method of manufacturing the bipolar transistor of FIG. 2 will now be described with reference to FIGS. 3 (A) through 3(F).

Referring first to FIG. 3(A), STI or LOCOS insulating regions 220 are formed in the surface of an N-collector region 210. The N- collector region 210 may be formed by epitaxial growth over a P- substrate (not shown). Also, an overdoped N+ collector region may be formed at reference number 211 through the N- collector region 210 to contact a buried N+ collector region (not shown).

Still referring to FIG. 3(A), a base layer 230 is formed by epitaxial growth of single-crystalline Si or SiGe. For example, in the case of a heterojunction device, the base layer 230 may be a SiGe layer comprised of a stack of a Si seed layer, a SiGe spacer layer, a doped-SiGe layer, and a Si capping layer. Then, first and second insulating layers 240 and 250 are sequentially deposited on the base layer 230.

Next, as shown in FIG. 3(B), emitter window 215 is formed through the insulating layers 250 and 240 to expose a surface portion of the base layer 230. At this time, the previously mentioned overdoped N+ collector region may be formed by ion implantation through the emitter window 215. Alternately, to avoid ion implantation damage to the base layer 230, the overdoped N+ collector region can be formed prior to deposition of the base layer 230 by using a photoresist mask pattern. In either case, the emitter window 215 is formed.

Next, still referring to FIG. 3(B), an emitter electrode layer 260 and an insulating layer 270 are formed. As shown, the emitter electrode layer 260 fills the emitter window 215 so as to contact the exposed surface region of the base layer 230.

The emitter electrode layer 260 may be formed as a poly-crystal and/or epitaxial layer of Si, SiGe or a composite thereof. Further, the emitter electrode layer 260 is N+ doped either in situ or by ion implantation, and preferably has a graded impurity concentration distribution in which an upper part of the emitter electrode layer 260 has a higher concentration than a lower part thereof. For example, the impurity concentration in the upper part may be in a range of 1x10¹⁹/cm³ to 1x10²²/cm³, whereas the impurity concentration in the lower part may be in a range of 1x10¹⁸/cm³ to 1x10²⁰/cm³.

Next, referring to FIG. 3(C), an emitter region 240 may be formed by diffusion of impurities from the emitter electrode layer 260 into an upper portion of the base layer 230. The diffusion may progress during epitaxial growth of the emitter electrode layer 260, or during a heat treatment process subsequent to formation of the emitter electrode layer 260. Alternately, the emitter region 260 may be formed by ion implantation prior to formation of the emitter electrode layer 260. In the case of a heterojunction device in which the base layer 230 is a SiGe layer, the emitter region 240 is formed in the Si capping layer or in the Si capping layer and doped-SiGe layer of the base layer 230.

Next, still referring to FIG. 3(C), the emitter electrode layer 260 and insulating layers 250 and 270 (FIG. 3(B)) are patterned by etching or chemical mechanical polishing to define an emitter electrode 261 having an top surface covered by an insulating layer 271. Portions of the insulating layer 250 (FIG. 3(B)) which remain after patterning are identified by reference numbers 251 in FIG. 3(C). Insulating sidewall spacers 280 are then formed on the sidewalls of the emitter electrode 261 and insulating layers 251 and 271. Further, either before or after formation of the spacers 280, base regions (not shown) may optionally be formed in the N- collector region 210 by ion implantation of p-type impurities.

Referring now to FIG. 3(D), the insulating layer 240 (FIG. 3(C)) is etched to define insulating layers 251 beneath the insulating layers 251 and sidewall spacers 280. Then, a base electrode layer 240 is formed over the resultant structure so as to contact the base layer 230. The base electrode layer 240 may be formed of poly-silicon.

Referring next to FIG. 3(E), the base electrode layer base layer 290 (FIG. 3(D)) patterned by etching to define the base electrode 291. As shown, in this embodiment, a portion of the base electrode 291 extends over the emitter electrode 261 and is isolated from the emitter electrode 261 by the insulating layer 271.

Next, as shown in FIG. 3(F), the insulating layer 271 is etch to expose an upper surface portion of the emitter electrode 261. Etching of the insulating layer 271 may be carried out in the same etching process used to define the emitter electrode 261. Then, a silicidation process is executed to form a silicide layer 295 on all or part of an upper surface of the base electrode 291, and a silicide layer 265 on all or part of an upper surface of the emitter electrode 261. Although not shown, a silicide layer may be simultaneously formed on all or part of an upper surface of the non-illustrated collector of the device.(Not on a part of each electrode. To be precise, Silicide layer may be formed on all or one of the emitter electrode, base electrode, and collector electrode.) An insulating layer 330 is then deposited over the resultant structure, and contact holes are etched to expose the silicide layers 295 and 265. Finally, metal interconnects 310 and 320 are filled into the contact holes as shown.

As described above, the emitter electrode 261 is formed prior to formation of the base electrode 291. This allows for a reduction in the profile height of the emitter electrode 261, which in turns shortens the electrical pathway within the emitter electrode 261. Further, since the emitter electrode 261 is buried deeper within the insulating layer 330, the exposure to plasma during etching of the contact holes is reduced at the upper surface of the emitter electrode 261. Thus, any damage to the silicide layer 265 is minimized. Consequently, the resistance at the interface with the interconnect 310 is reduced, and the current gain and speed of the bipolar transistor are increased.

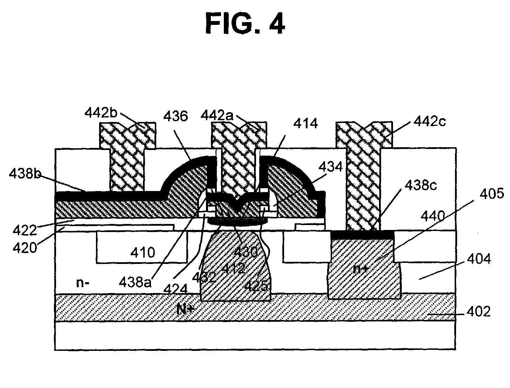

Attention is now directed to FIG. 4, which illustrates a second embodiment of the present invention. This embodiment differs from that of FIG. 2 in that a one, rather than two, base contacts are provided. Also, for completeness of explanation, the formation of the collector contact is also shown and described.

In this example, an NPN transistor is shown, and accordingly, an N+ buried collector region 402 is located at a depth within an N- collector region 404 formed of a single-crystalline structure. Also, as shown, LOCUS or STI insulating layers 410 are included to isolate surface regions of the N- collector region 404.

A single-crystal P+ base layer 422 is located over the N- collector region 404, and an N+ single-crystalline emitter region 414 extends to a given depth within the P+ base layer 422. Optionally, although not shown in FIG. 4, P+ base regions may be formed at a depth below the base layer 422. As examples only, the base layer 422 may be a single layer of Si, or a heterojunction layer formed of stacked layers of SiGe and Si.

A base electrode 436 is located on an upper surface of the base layer 422 and contacts a metal base contact 442b extending through an insulating (or dielectric) layer 440. The base electrode 436 may be covered with a silicide layer 438b to improve electrical connection to the base contact 442b.

An N+ emitter electrode 430 contacts an upper surface of the emitter region 414 and contacts a metal emitter contact 442a extending through the insulating layer 440. Also, the emitter electrode 430 may be covered with a silicide layer 438a to improve electrical connection to the emitter contact 442a.

The emitter electrode 430 is electrically insulated from the base electrode 436 by sidewall spacers 434 and insulating layers 424, 425 and 432.

An overdoped N+ region 412 is located below the emitter region 414 and extends between the base layer 422 and the N+ buried collector region 402. Likewise, an N+ collector sink 405 extends from the N+ buried collector region 402 to the surface of the device for connection to a metal collector contact 442c via a silicide layer 438c.

Finally, reference number 420 denotes one or more insulating layers and/or poly-silicon layers, respectively, which may optionally included in the bipolar transistor.

As with the first embodiment, the device of FIG. 4 is characterized in that a vertical profile of at least a portion the base electrode 436 is equal to or greater than a vertical profile of the emitter electrode 430. Also, a vertical length through the insulating layer 440 of the emitter metal contacts 442a is preferably equal to or more than a vertical length through the insulating layer 442b of the base metal contact 442b. This configuration may be optionally achieved by the latter described method of manufacture of an embodiment of the present invention. The profile height of the emitter electrode 430 is substantially reduced, thereby shortening the electrical pathway within the emitter electrode 430. The emitter resistive component of the device is decreased as a result, thus improving performance. Further improvements in emitter characteristics are realized in the case where the device of FIG. 4 is manufactured according to the method of manufacture described next.

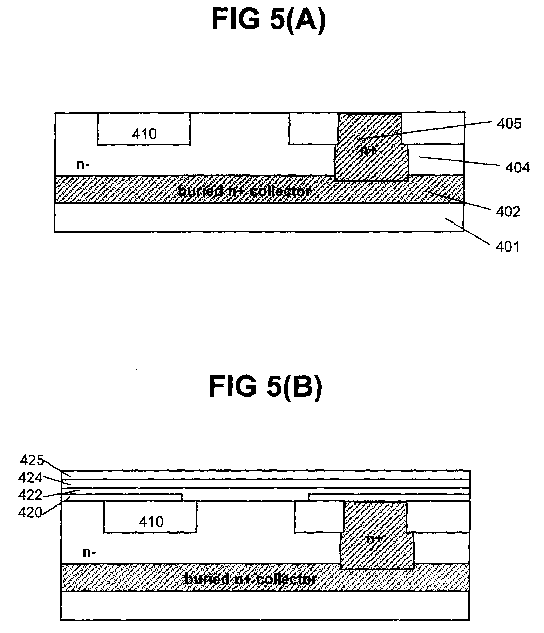

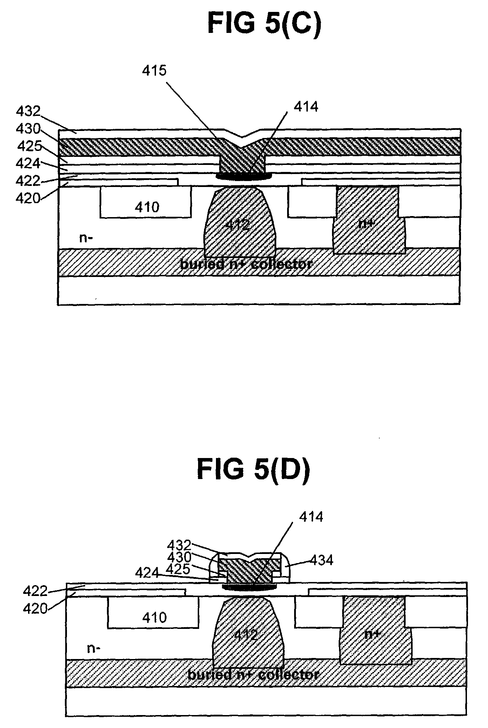

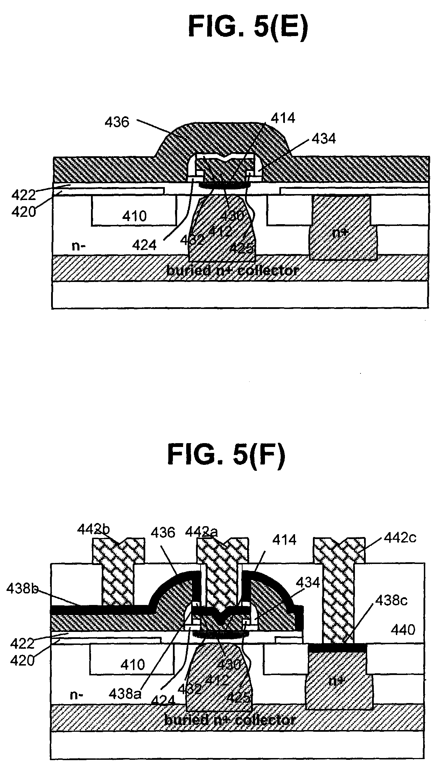

A method of manufacturing the bipolar transistor of FIG. 4 will now be described with reference to FIGS. 5 (A) through 5(F).

Referring first to FIG. 5(A), a buried N+ collector region 402 and an N- collector region 404 are formed in a p-type semiconductor substrate 401. STI or LOCOS insulating regions 410 are then formed in the surface of the N- collector region 404, and an N+ collector sink 405 is formed through the N- collector region 404 to contact the N+ collector region 402.

Referring to FIG. 5(B), one or more insulating layers and/or poly-silicon layers 420 are optionally patterned over the N- collector region 404. Insulating material examples of the layers 420 include SiN, SiON and Si02. Then, a base layer 422 is formed by epitaxial growth of single-crystalline Si or SiGe. For example, in the case of a heterojunction device, the base layer 422 may be a SiGe layer comprised of a stack of a Si seed layer, a SiGe spacer layer, a doped-SiGe layer, and a Si capping layer. Then, first and second insulating layers 424 and 425 are sequentially formed over the base layer 422.

Next, as shown in FIG. 5(C), emitter window 415 is formed through the insulating layers 425 and 424 to expose a surface portion of the base layer 422. At this time, an overdoped N+ collector region 412 may be formed by ion implantation through the emitter window 415. Alternately, to avoid ion implantation damage to the base layer 422, the overdoped N+ collector region 412 can be formed prior to deposition of the base layer 422 by using a photoresist mask pattern. In either case, the emitter window 415 is formed.

Next, still referring to FIG. 5(C), an emitter electrode layer 430 and an insulating layer 432 are formed. As shown, the emitter electrode layer 430 fills the emitter window 415 so as to contact the exposed surface region of the base layer 422.

The emitter electrode layer 430 may be formed as a poly-crystal and/or epitaxial layer of Si, SiGe or a composite thereof. Further, the emitter electrode layer 430 is N+ doped either in situ or by ion implantation, and preferably has a graded impurity concentration distribution in which an upper part of the emitter electrode layer 430 has a higher concentration than a lower part thereof. For example, the impurity concentration in the upper part may be in a range of 1x10¹⁹/cm³ to 1x10²²/cm³, whereas the impurity concentration in the lower part may be in a range of 1x10¹⁸/cm³ to 1x10²⁰/cm³.

Next, still referring to FIG. 5(C), an emitter region 414 may be formed by diffusion of impurities from the emitter electrode layer 430 into an upper portion of the base layer 422. The diffusion may progress during epitaxial growth of the emitter electrode layer 430, or during a heat treatment process subsequent to formation of the emitter electrode layer 430. Alternately, the emitter region 414 may be formed by ion implantation prior to formation of the emitter electrode layer 430. In the case of a heterojunction device in which the base layer 422 is a SiGe layer, the emitter region 422 is formed in the Si capping layer or in the Si capping layer and doped-SiGe layer of the base layer 422.

Next, referring to FIG. 5(D), the emitter electrode layer 430 and insulating layers 432 and 425 are patterned by etching or chemical mechanical polishing to define the emitter electrode 430 having an upper surface covered by a remaining portion of the insulating layer 432. Insulating sidewall spacers 434 are then formed on the sidewalls of the emitter electrode 430 and insulating layers 432 and 425. The insulating layer 424 is then etched such that portions remain beneath the insulating layers 425 and sidewall spacers 434. Also, either before or after formation of the spacers 434, base regions (not shown) may optionally be formed in the N- collector region by ion implantation of p-type impurities.

Then, referring to FIG. 5(E), a base electrode layer 436 is formed over the structure of FIG. 5(c) so as to contact the base layer 422. The base electrode layer 436 may be formed of poly-silicon.

Referring next to FIG. 5(F), the base electrode layer base layer is patterned by etching to define the base electrode 436, and to expose the emitter electrode 430 and the N+ collector sink 405. As shown, in this embodiment, a portion of the base electrode 436 extends over the emitter electrode 430 and is isolated from the emitter electrode 430 by the insulating layer 432 remaining after etching.

Then, still referring to FIG. 5(F), a silicidation process is executed to form silicide layers 438a, 438b and 438c on the emitter electrode 430, the base electrode 436 and the collector sink 405, respectively. An insulating layer 440 is then deposited over the resultant structure, and contact holes are etched to expose the silicide layers 438a, 438b and 438c. Finally, metal interconnects 442a, 442b and 442c are filled into the contact holes as shown.

Like the previous embodiment, the method of FIGS. 5(A) through 5(F) is characterized in that the emitter electrode 430 is formed prior to formation of the base electrode 436. This allows for a reduction in the profile height of the emitter electrode 430, which in turns shortens the electrical pathway within the emitter electrode 430. Further, since the emitter electrode 430 is buried deeper within the insulating layer 440, the exposure to plasma during etching of the contact holes is reduced at the upper surface of the emitter electrode 430. Thus, any damage to the silicide layer 438a is minimized. Consequently, the resistance at the interface with the interconnect 442a is reduced, and the current gain and speed of the bipolar transistor are increased.

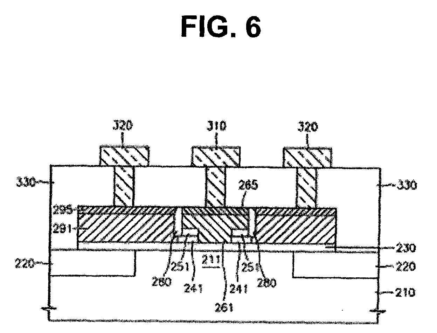

Attention is now directed to FIG. 6, which illustrates another embodiment of the present invention. This embodiment differs from that of the previous embodiments in that the upper surfaces of the base and emitter electrodes are co-planar.

In FIG. 6, the same reference numbers are used to denote the same elements as those shown and described in connection with FIG. 2. Accordingly, to avoid redundancy, a detailed description of those elements will not be repeated here. However, as mentioned above, the embodiment of FIG. 6 is characterized by co-planar top surfaces of the emitter electrode 261 and base electrode 291. This configuration results in the same advantages as the previous embodiments. That is, the electrical pathway of emitter electrode 261 is relatively short, thus decreasing the emitter resistance. Further improvements are realized in the case where the device of FIG. 6 is manufactured according to the method of manufacture described next.

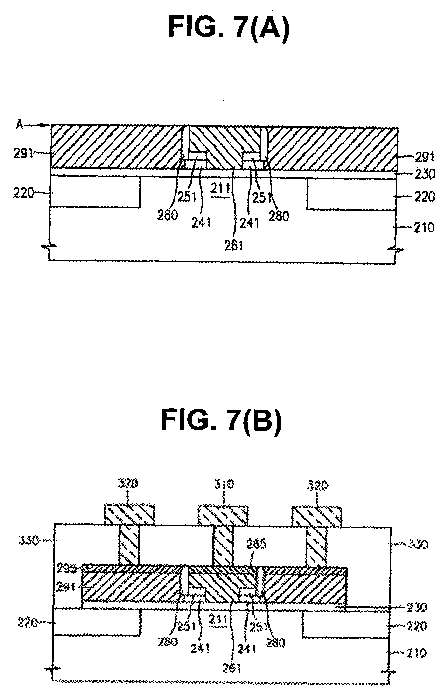

A method of manufacturing the bipolar transistor of FIG. 6 will now be described with reference to FIGS. 7 (A) and 7(B).

First, a structure such as that shown in previously described FIG. 3(D) is obtained. However, the insulating layer 271 of FIG. 3(D) can be omitted. Then, referring to FIG. 7(A), the structure is planarized, for example by a chemical-mechanical polishing (CMP) process. The planarization process is continued until the base electrode layer 291 is electrically isolated from the emitter electrode 261 by the sidewall spacers 280. As a result, the surfaces of the base electrode layer 291 and emitter electrode 261 are co-planar.

Then, referring to FIG. 7(B), the base electrode layer 291 is patterned, and a silicidation process is executed to form silicide layers 295 and 265 on the base electrode 291 and emitter electrode 261, respectively. An insulating layer 330 is then deposited over the resultant structure, and contact holes are etched to expose the silicide layers 295 and 265. Finally, metal interconnects 320 and 310 are filled into the contact holes as shown.

Like the previous embodiments, the method of FIGS. 7(A) through 7(b) is characterized by a reduction in the profile height of the emitter electrode 261, and by less damaging exposure of the emitter electrode 261 to plasma during etching of the contact holes. Other advantages of this embodiment are the simplicity of the process (e.g., insulating layer 271 can be omitted), and a reduced parasitic capacitance resulting from less insulator between adjacent electrodes. Further, due to the CMP process, it is not necessary for the emitter electrode layer to be deposited prior to the base electrode layer. For example, a base electrode layer can be first deposited with an emitter window formed therein, and with insulating sidewall spacers formed in the emitter window. The emitter electrode layer can then be formed in the emitter window and over the base electrode layer. The resultant structure can then be subjected to a CMP process until the base electrode layer is electrically isolated from the emitter electrode layer by the sidewall spacers. Another variation is to deposit or grow the emitter and base electrode material simultaneously. In this case, an insulating material for isolating the electrodes would be deposited before or after the electrode material is formed.

In the drawings and specification, there have been disclosed typical preferred embodiments of this invention and, although specific examples are set forth, they are used in a generic and descriptive sense only and not for purposes of limitation. It should therefore be understood the scope of the present invention is to be construed by the appended claims, and not by the exemplary embodiments.

## Claims

1. A bipolar transistor, comprising:
a substrate having a collector region of a first conductivity type;
a base layer of a second conductivity type extending horizontally over the collector region;
an emitter region of the first conductivity type at least partially contained in the base layer;
an emitter electrode confronting an upper surface of the emitter region;
a base electrode confronting an upper surface of the base layer;
wherein a vertical profile of at least a portion the base electrode is equal to or greater than a vertical profile of the emitter electrode.

2. The bipolar transistor of claim 1, further comprising a silicide layer on top surfaces of at least one of the base electrode and the emitter electrode.

3. The bipolar transistor of claim 1, wherein the emitter electrode comprises a polysilicon layer.

4. The bipolar transistor of claim 1, wherein the emitter electrode comprises an epitaxial layer.

5. The bipolar transistor of claim 1, wherein the vertical profile of at least a portion the base electrode is greater than the vertical profile of the emitter electrode.

6. The bipolar transistor of claim 5, wherein the base electrode partially overlaps an upper surface of the emitter electrode in a vertical direction.

7. The bipolar transistor of claim 6, further comprising at least one insulating layer horizontally interposed between the base electrode and the upper surface of the emitter electrode.

8. The bipolar transistor of claim 5, wherein the base layer is a heterojunction base layer.

9. The bipolar transistor of claim 8, wherein the base layer comprises layers of Si and SiGe.

10. The bipolar transistor of claim 1, wherein the base electrode does not overlap an upper surface of the emitter electrode in a vertical direction.

11. The bipolar transistor of claim 10, wherein an upper surface of the base electrode and an upper surface of the emitter electrode are coplanar.

12. The bipolar transistor of claim 11, wherein the upper surfaces of the base electrode and the emitter electrode are chemical mechanical polished surfaces.

13. The bipolar transistor of claim 11, wherein the base layer is a heterojunction base layer.

14. The bipolar transistor of claim 13, wherein the base layer comprises layers of Si and SiGe.

15. A bipolar transistor, comprising:
a substrate having a collector region of a first conductivity type;
a base layer of a second conductivity type extending horizontally over the collector region;
an emitter region of the first conductivity type at least partially contained in the base layer;
an emitter electrode of the first conductivity type confronting an upper surface of the emitter region;
a base electrode of the second conductivity type confronting an upper surface of the base layer;
an insulating layer located over the emitter electrode and the base electrode;
a first metal contact extending vertically through the insulating layer to an upper surface of the base electrode; and
a second metal contact extending vertically through the insulating layer to an upper surface of the emitter electrode;
wherein a vertical length through the insulating layer of the second metal contact is equal to or more than a vertical length through the insulating layer of the first metal contact.

16. The bipolar transistor of claim 15, further comprising at least one of a first silicide layer interposed between the upper surface of the base electrode and the first metal contact, and a second silicide layer interposed between the upper surface of the emitter electrode and the second metal contact.

17. The bipolar transistor of claim 15, wherein the emitter electrode comprises a polysilicon layer.

18. The bipolar transistor of claim 15, wherein the emitter electrode comprises an epitaxial layer.

19. The bipolar transistor of claim 15, wherein the base layer is a heterojunction base layer.

20. The bipolar transistor of claim 19, wherein the base layer comprises layers of Si and SiGe.

21. The bipolar transistor of claim 15, wherein the vertical length through the insulating layer of the first metal contact is greater than the vertical length through the insulating layer of the second metal contact.

22. A method of manufacturing a bipolar transistor, comprising:
forming an emitter electrode of a first conductivity type over a first portion of a base layer of a second conductivity type, wherein the base layer is located over a collector region of the first conductivity type; and
forming an emitter region of a first conductivity type at least partially within the first portion of the base layer;
forming a base electrode of the second conductivity type over a second portion of the base layer;
wherein the base electrode is formed after the emitter electrode is formed.

23. The method of claim 22, wherein the emitter region is formed prior to formation of the emitter electrode.

24. The method of claim 22, wherein the emitter region is formed after formation of the emitter electrode.

25. The method of claim 24, wherein the emitter region is formed by diffusion of impurities from the emitter electrode into the base layer.

26. The method of claim 22, wherein formation of the emitter electrode comprises deposition of poly-silicon.

27. The method of claim 22, wherein formation of the emitter electrode comprises epitaxial growth from the base layer.

28. The method of claim 22, wherein formation of the emitter electrode comprises:
forming an insulating layer over the base layer;
forming a window in the insulating layer to expose the first portion of the base layer;
forming a conductive layer of the first conductivity type over the insulating layer and the first portion of the base layer within the window; and
etching the conductive layer to define the emitter electrode.

29. The method of claim 22, wherein formation of the base electrode comprises:
forming a conductive layer of the second conductivity type over the second portion of the base layer and the emitter electrode, the conductive layer being electrically insulated from the emitter electrode; and
etching at least a portion of the base electrode which is located over the emitter electrode.

30. The method of claim 29, further comprising forming an emitter contact within the etched portion of the base electrode and electrically insulated from the base electrode.

31. The method of claim 22, wherein formation of the emitter electrode comprises:
depositing a first insulating layer over the base layer;
forming a window in the first insulating layer to expose the first portion of the base layer;
forming a conductive layer of the first conductivity type over the first insulating layer and the first portion of the base layer within the window;
forming a second insulating layer on the conductive layer; and
etching the conductive layer and the second insulating layer to define the emitter electrode, wherein an upper surface of the emitter electrode is covered with the second insulating layer.

32. The method of claim 31, further comprising forming insulating sidewall spacers on sidewalls of the emitter electrode.

33. The method of claim 32, wherein formation of the base electrode comprises:
forming a second conductive layer of the second conductivity type over the second portion of the base layer and the emitter electrode, the conductive layer being electrically insulated from the emitter electrode by the sidewall spacers and the second insulating layer;
etching a second window in the second conductive layer to expose an upper surface of the second insulating layer,
wherein the second window is aligned over the emitter electrode.

34. The method of claim 33, further comprising:
forming a third insulating layer over the second conductive layer and within the second window;
etching a third window within the second and third insulating layers to expose an upper surface of the emitter electrode; and
forming an emitter contact within the third window.

35. The method of claim 34, wherein a width of the first window is greater than a width of the second window such that a portion of the base electrode partially overlaps an upper surface of the emitter electrode.

36. The method of claim 22, further comprising forming a first silicide layer on the base electrode and a second silicide layer on the emitter electrode.

37. The method of claim 36, further comprising forming a first metal contact which extends through an insulating layer and contacts the first silicide layer, and a second metal contact which extends through the insulating layer and contacts the second metal contact.

38. The method of claim 37, wherein a vertical length through the insulating layer of the second metal contact is equal to or more than a vertical length through the insulating layer of the first metal contact.

39. A method for forming a bipolar transistor, comprising:
forming an emitter region of a first conductivity type at least partially within a first portion of a base layer of a second conductivity type, wherein the base layer is located over a collector region of the first conductivity type; and
forming an emitter electrode layer of a first conductivity type over the first portion of the base layer of a second conductivity type;
forming a base electrode layer of the second conductivity type over a second portion of the base layer; and
planarizing the emitter electrode layer and the base electrode layer to form an emitter electrode and a base electrode having coplanar surfaces.

40. The method of claim 39, wherein the planarization includes subjecting the emitter electrode layer and the base electrode layer to chemical mechanical polishing.

41. The method of claim 39, wherein the emitter electrode layer is formed prior to formation of the base electrode layer.

42. The method of claim 39, wherein the emitter electrode layer is formed after formation of the base electrode layer.

43. The method of claim 39, wherein the emitter electrode layer is formed simultaneously with formation of the base electrode layer.

44. The method of claim 39, further comprising forming a first silicide layer on the base electrode and a second silicide layer on the emitter electrode.

45. The method of claim 39, further comprising forming a first metal contact which extends through an insulating layer and contacts the first silicide layer, and a second metal contact which extends through the insulating layer and contacts the second metal contact.
